# EUROPÄISCHE PATENTANMELDUNG

(11) **EP 1 601 018 A1**
(43) Veröffentlichungstag der Anmeldung: **30.11.2005**
(21) Anmeldenummer: 04017246.2
(22) Anmeldetag: 21.07.2004
(51) Int. Cl.: H01L 27/00, G02F 1/13

(54) **Verfahren zum Herstellen von organischen, Licht emittierenden Flächenelementen und organisches Licht emittierendes Flächenelement**

(30) Priorität: 25.05.2004 DE 102004025578
(71) Anmelder: Applied Films GmbH & Co. KG, 63755 Alzenau (DE)
(72) Erfinder: Hoffmann, Uwe, Dr., 63755 Alzenau (DE)
(74) Vertreter: GROSSE BOCKHORNI SCHUMACHER

(57) **Zusammenfassung**

Mit einem Verfahren zum Herstellen von organischen, Licht emittierenden Flächenelementen (OLED), wobei auf einem Substrat nacheinander zunächst eine erste Flächenelektrode, eine organische Funktionsschicht und eine zweite Flächenelektrode aufgetragen werden, wird die zweite Flächenelektrode in Gestalt eines Interferenz-Schichtsystems mit n metallischen Teilschichten und n+1 oxidischen Teilschichten hergestellt, die jeweils paarweise eine metallische Teilschicht zwischen sich einschließen, wobei n ganzzahlig und ≥ 1 ist. Damit wird der Vorteil einer sehr hohen Lichttransmission für den Aufbau von großflächigen topemitter-OLED bei zugleich sehr geringem Flächenwiderstand der substratfernen Flächenelektrode erzielt, wodurch ein Betrieb mit weniger als 10 V ermöglicht wird.

## Beschreibung

Die Erfindung bezieht sich auf ein Verfahren zum Herstellen von organischen, Licht emittierenden Flächenelementen mit den Merkmalen des Oberbegriffs des Patentanspruchs 1 und auf organische, Licht emittierende Flächenelemente, die insbesondere mit diesem Verfahren herstellbar sind.

Derartige Flächenelemente sind auch unter der Abkürzung OLED (für "organic light emitting diode") bekannt, die im Folgenden verwendet wird. Wesentlicher Bestandteil dieser OLED sind auf organischen Materialien beruhende Funktionsschichtsysteme oder Mehrfachschichten, die bei der Herstellung insbesondere hinsichtlich der Temperaturen gewisse Grenzen setzt. Der grundsätzliche Aufbau solcher OLED besteht aus einem starren oder flexiblen Substrat (Glas, Kunststoff, Wafer, Leiterplatte, Folie etc.), auf das zunächst eine zumeist transparente Flächenelektrode (Frontelektrode) und sodann das eigentliche Licht emittierende Schichtsystem aufgebracht wird. Auf letzteres wird wiederum eine Flächenelektrode (Rückelektrode) aufgebracht. Licht wird erzeugt, sobald an die beiden Flächenelektroden eine elektrische Spannung angelegt wird und ein Strom zwischen ihnen fließt.

Bekannt sind sowohl OLED mit nicht transparenten Rückelektroden (z. B. US 4,539,507), die auch als "bottom emitter" bezeichnet werden, weil sie das Licht durch das transparente Substrat abstrahlen, als auch solche mit transparenten Rückelektroden (vgl. US 5,703,436 und 5,707,745), die auf nicht transparenten Substraten aufgebaut sein können und dann auch als "top emitter" bezeichnet werden. Im letzteren Fall können die OLED aber auch vollständig transparent sein, wenn auch das Substrat sowie das Funktionsschichtsystem wenigstens im ausgeschalteten Zustand transparent sind.

Da OLED Strom in Licht umsetzen, müssen die beiden Elektroden bei großflächigen Elementen erhebliche Ströme leiten können. Typische Stromdichten liegen bei bis zu 50 mA/cm². Hierbei treten jedoch Konflikte zwischen den Anforderungen an die Lichttransparenz und die mit geringeren Flächenwiderständen normalerweise einhergehenden größeren Schichtdicken der Flächenelektroden auf. Man versteht ohne weiteres, dass eine vergleichsweise dickere (metallische oder leitfähige oxidische) Elektrode zugleich einen geringeren Flächenwiderstand und eine geringere Lichttransmission hat.

Die elektrische Spannung wird den Flächenelektroden entweder über Kammelektroden (das können z. B. dünne metallische Leiterbahnen sein, die über die Fläche der Flächenelektrode verteilt angeordnet sind) oder häufiger über am Rand der Flächenelektroden aufgebrachte Sammelleiter (bus bars) zugeführt. Letztere Variante hat den Vorteil, dass die seitlichen Sammelleiter im Randbereich optisch kaschiert werden können und bei Durchsicht durch das Leuchtelement nicht sichtbar sind.

Bei Display-Anwendungen sind transparente (substratnahe) Frontelektroden aus Indium-Zinn-Oxid (ITO) weit verbreitet. Diese haben z. B. eine Dicke von 150 mn und einen Flächenwiderstand von etwa 10 Ω/Quadrateinheit (was einen spezifischen Widerstand von 150 µΩ/cm ergibt). Hieraus ergibt sich bei einem Strom von 2,5 A über die beidseitig über bus bars kontaktierte Flächenelektrode ein Spannungsabfall vom einen Rand des Displays bis zu dessen Mitte von 12,5 V. Dies lässt sich jedoch nicht mit vorgesehenen Betriebsspannungen von 10 V vereinbaren.

Abgesehen davon lassen sich so geringe Flächenwiderstände auch nur erreichen, wenn die Elektrodenschichten bei Substrattemperaturen von 200 °C und mehr abgeschieden werden (z. B. durch Sputtern - magnetfeldunterstützte Kathodenzerstäubung). Das macht solche Elektroden als (substratferne) Rückelektroden für OLED uninteressant, denn die organischen Schichten würden sich bei so hohen Temperaturen zersetzen.

Es sind zwar auch Flächenelektroden aus reinen Metallschichten (Gold, Silber etc.) denkbar, diese sind aber wiederum nur bei sehr geringen Dicken und relativ hohen Flächenwiderständen hinreichend transparent (für Gold vgl. X. Zhou et al., Appl. Phys. Lett. 81 (2002), 922).

Es ist bekannt, optisch hoch transparente Schichtsysteme auf Glas- oder Kunststoffsubstraten als infrarote Strahlung reflektierende Wärmedämmschichten zu verwenden. Man nennt diese Schichtsysteme auch "Interferenz-Schichtsysteme", da sie aus ausgewählten Folgen von dielektrischen (oxidischen, oxinitridischen ...) und metallischen Schichten mit unterschiedlichen Brechungsindizes bestehen. Die dielektrischen Schichten haben eine entspiegelnde Wirkung auf die Metallschichten, so dass deren an sich hohe Lichtreflexion gebrochen wird. Diese Schichtsysteme zeichnen sich deshalb bei sehr geringer Dicke (im Bereich weniger Nanometer) und sehr geringem ohmschem Flächenwiderstand (deutlich weniger als 10 Ω/Quadrateinheit) zugleich durch eine sehr hohe Lichttransmission von mehr als 75 % aus.

Solche Schichtsysteme sind auch als substratnahe Elektroden für großflächige Displays (z. B. Flachmonitore) beschrieben worden (DE 197 33 053 A1, DE 199 48 839 A1, DE 100 39 412 A1), wobei auch mehr als eine Metallschicht vorgesehen sein kann und jede Metallschicht jeweils zwischen zwei dielektrischen Schichten eingebettet ist. Man kann als oxidische Schichten ITO und als Metallschicht(en) Silber verwenden. Solche Elektroden kamen jedoch bislang bei Display-Anwendungen von OLED kaum zum Einsatz. Zum einen reichen für LCD-Displays die mit herkömmlichen ITO-Elektroden zu erreichenden Leitfähigkeiten (bei zugleich hoher Transparenz) vollkommen aus. Zum anderen werden die Schichten nach der Abscheidung fast immer nasschemisch strukturiert (in Segmente unterteilt), was bei mehrlagigen Schichtsystemen schwierig realisierbar ist, da die Oxid- und die Metallschichten sich beim Ätzen unterschiedlich verhalten und man somit keine sehr sauberen Trennlinien einarbeiten kann. Es ist allerdings auch schon bekannt, solche Schichtsysteme mithilfe von Laserstrahlen zu strukturieren.

Die Erfindung hat die Aufgabe, bei einem organischen, Licht emittierenden Flächenelement der eingangs genannten Art eine hohe Lichttransmission auch auf der substratfernen Seite zu ermöglichen, wobei ein möglichst geringer Flächenwiderstand der substratfernen Elektrode erhalten werden soll und deren Abscheidung bei Temperaturen möglich sein soll, die mit den organischen Funktionsschichten verträglich sind.

Diese Aufgabe wird erfindungsgemäß dadurch gelöst, dass man auf das Flächenelement nach dem Aufbringen der Funktionsschichten ein Interferenz-Schichtsystem aus mindestens einer Metallschicht und mindestens zwei die Metallschicht zwischen sich einschließenden oxidischen Schichten aufbringt. Diese oxidischen Schichten können auch unter dem Begriff "TCO" -transparent conductive oxides- zusammengefasst werden. Hierbei ist Indium-Zinn-Oxid bzw. ITO nur eines von mehreren möglichen Materialien, jedoch zugleich das am weitesten für diese Anwendung verbreitete. Auch ICO -Indium-Cer-Oxid- kann hier Anwendung finden. Auch aus Zinn- und Zinkoxid können TCO-Schichten hergestellt werden, wobei die Leitfähigkeit ggf. durch eine metallische Dotierung verbessert oder hergestellt wird.

Solche Schichtsysteme werden auch als "IMI"-Schichten bezeichnet, worin "I" für ITO und "M" für Metallschicht steht. Sieht man zwei (oder mehr) Metallschichten jeweils mit zwischenliegender TCO-Schicht vor, so kann man sie als IMIMI-Schichten bezeichnen. Diese Bezeichnung schließt jedoch die Verwendung anderer TCO-Materialien nicht aus.

Zwar sind, wie schon erwähnt, solche Schichtsysteme an sich bekannt, jedoch hat sich ihre Verwendung als substratferne Deckelektrode dem Fachmann nicht angeboten. Man kann z. B. solche Schichtsysteme nicht vollständig aufbringen und dann insgesamt strukturieren (lokal ätzen), sondern muss Schicht für Schicht ätzen. Außerdem war man bislang der Auffassung, dass die organischen Licht emittierenden Schichten zu wenig temperaturfest seien, um das Abscheiden eines Schichtsystems der hier in Rede stehenden Art zu ertragen. Normalerweise trägt man einzelne ITO-Schichten auf Substrate bei relativ hohen Temperaturen auf, um einen möglichst niedrigen Flächenwiderstand der Schicht zu erreichen. Ferner kann ITO nur durch Sputtern und nicht durch Aufdampfen abgeschieden werden, wobei die gesputterten Partikel mit hoher Energie (bis zu 10 eV) auf die Substratoberfläche aufprallen. Bei den üblichen Aufdampfprozessen haben die auftreffenden Teilchen wesentlich geringere Energien von maximal 0,3 eV, die von organischen Schichten schadlos ertragen werden konnten.

Solche transparenten Flächenelektroden sind vor allem als Deckschichten für "top emitter"-OLED ideal geeignet (Passiv-Matrix, Aktiv-Matrix, Pixel-Displays, Leuchtsymbole) und für Leuchtflächen (Lampen, Verkleidungen, Tapeten etc.) geeignet, bei denen das Substrat selbst nicht von dem emittierten Licht durchstrahlt werden muss / soll.

Es versteht sich, dass beim Abscheiden des Interferenz-Schichtsystems die Prozess-Temperaturen im Substrat nicht die Werte übersteigen dürfen, die von den organischen Funktionsschichten schadlos ertragen werden. Diese Temperaturgrenze liegt bei etwa 80 °C; sie kann bei Abscheidung der substratfernen Flächenelektrode durch Sputtern eingehalten werden. Ggf. kann man eine Kühlung des Substrats und der bereits darauf abgeschiedenen Schichten vorsehen.

Diese substratferne Flächenelektrode muss nach ihrer Abscheidung nicht strukturiert / unterteilt werden, sondern dient im Anwendungsfall "Display" lediglich als gemeinsame Sammelelektrode für sämtliche Pixel des Displays. Die Pixel werden individuell oder "pixelweise" angesteuert, indem die unter ihnen liegende substratnahe Elektrode unterteilt (strukturiert) wird, wobei jedes Pixel über auf dem Substrat liegende Steuer- oder Busleitungen sowie zugehörige Schaltelektroniken aktivierbar ist. Ferner trennt man die Pixel durch isolierende Füllungen voneinander, so dass benachbarte Pixel nicht angesteuert werden.

Im Anwendungsfall "Leuchtfläche" muss keine der Flächenelektroden in sich unterteilt werden, da man auf eine möglichst homogene Stromversorgung auf ganzer Fläche Wert legt.

Die substratferne Flächenelektrode gemäß der Erfindung zeichnet sich durch einen hohen Haackeschen Gütefaktor aus, d. h. durch ein gutes Verhältnis zwischen der optischen Lichttransmission (in %) und dem Flächenwiderstand (in Ω / Quadrateinheit).

Infolge des Entfalls jeglicher Strukturierung der substratfernen Elektrode fällt die schlechte Ätzbarkeit des Schichtsystems nicht mehr nachteilig ins Gewicht. Man kann den Abscheide- bzw. Sputterprozess für das transparente leitfähige Oxid so einrichten, dass die Substrate bei Beschichtungsbeginn kalt sind und man mit kleiner Sputterleistung einsetzt. Diese kann mit fortschreitender Schichtdicke erhöht werden. Die damit erzeugte TCO-Schicht (z. B. aus ITO oder ICO) mag dann einen etwas erhöhten Flächenwiderstand aufweisen, jedoch wird dieser im Gesamt-Schichtsystem durch den geringen Widerstand der Metallschicht hauptsächlich bestimmt.

Nachdem erst einmal die erste TCO-Schicht auf das organische Schichtsystem abgeschieden wurde, schützt sie letzteres während der weiteren Schichtabscheidung, so dass die weitere Prozessführung relativ unproblematisch ist.

Durch Abscheiden eines "Sandwichs" aus mehreren Metallschichten, jeweils mit zwischenliegender TCO-Schicht, kann der Schichtwiderstand insgesamt noch weiter reduziert werden. Infolge der optischen Interferenzwirkung der TCO-Schichten bleiben auch solche Sandwich-Schichtsysteme hochgradig transparent für sichtbares Licht. Dagegen würde eine zu dicke Metallschicht alsbald opak.

Die TCO-Schichten können beim Sputtern vorzugsweise reaktiv (mit einem Sauerstoffanteil in der Arbeitsatmosphäre) aus Metall-Targets zerstäubt werden; man kann sie aber auch in einer inerten (Argon-)Atmosphäre aus oxidischen Targets abscheiden. Demgegenüber werden die metallischen Schichten natürlich in einer inerten (Argon-)Arbeitsatmosphäre abgeschieden.

Weitere Einzelheiten und Vorteile des Gegenstands der Erfindung gehen aus der Zeichnung eines Ausführungsbeispiels und deren sich im Folgenden anschließender eingehender Beschreibung hervor.

Es zeigen in schematischer Darstellung
- Fig. 1: eine Ansicht einer Aktiv-Matrix-OLED im Anwendungsfall "Display" mit einem hervorgehobenen einzelnen und individuell ansteuerbaren Pixel,
- Fig. 2: einen Querschnitt durch die OLED mit dem erfindungsgemäßen Aufbau.

Eine Aktiv-Matrix-OLED ist als Top-Emitter-Display auf einem Substrat 1 aufgebaut; der Rand 2 der insgesamt zum Emittieren von Licht aktivierbaren Leuchtfläche 3 hält umlaufend einen geringen Abstand vom Rand des Substrats 1 ein. In der Leuchtfläche 3 ist ein einzelner Pixel 4 nebst den zu ihm führenden Busleitungen 5 hervorgehoben. Der Pixel 4 wird über diese Leitungen individuell angesteuert. Die Gesamtheit der Leuchtfläche 3 ist mit weiteren, nicht dargestellten Pixeln bedeckt.

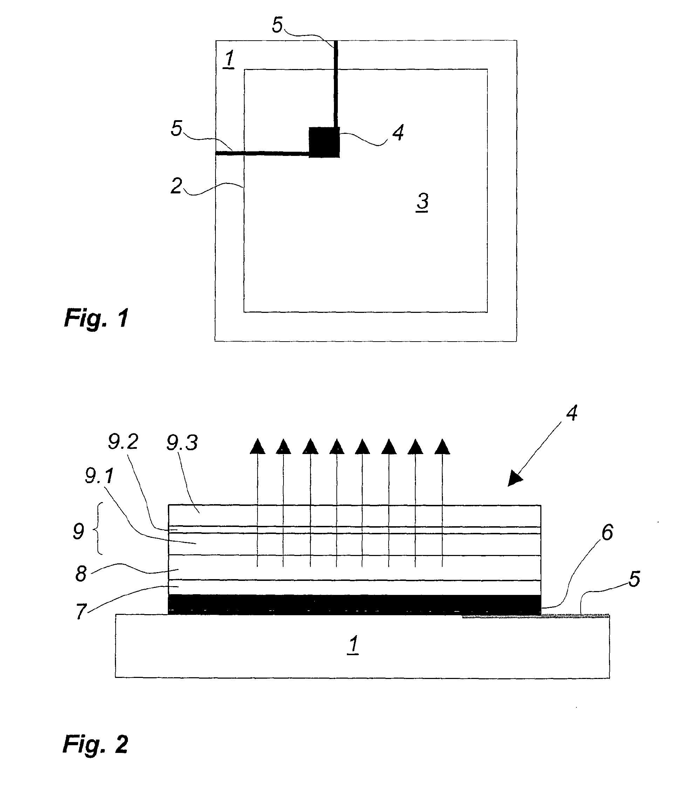

Fig. 2 verdeutlicht den Schichtaufbau dieser Aktiv-Matrix-OLED, die erfindungsgemäß mit einer transparenten IMI-Deckelektrode ausgestattet ist. Ausgehend vom Substrat 1 folgen die Busleitungen 5 und eine Schaltelektronik 6, sodann eine untere (substratnahe) und gerasterte Elektrode 7. Das Substrat 1 und die Rasterelektrode 7 können für sichtbares Licht transparent sein ("bottom emitter") oder opak (für "top emitter"). Auf der Elektrode 7, die z. B. aus ITO besteht, aus einem Metall oder aus einem Mehrfach-Schichtsystem der im eingangs erörterten Stand der Technik beschriebenen Art, ist eine Licht emittierende Funktionsschicht 8 aus organischen Materialien aufgebracht, die ihrerseits -nicht gezeigt- aus mehreren Teilschichten aufgebaut sein kann. Solche organischen, Licht emittierenden Funktionsschichten sind mannigfach vorbeschrieben, so dass hier nicht näher darauf eingegangen werden muss.

Oberhalb der Leuchtschicht ist eine insgesamt mit 9 bezeichnete hoch transparente, substratferne Flächenelektrode in Gestalt eines Interferenz-Schichtsystems abgeschieden. Dieses besteht aus einer unmittelbar auf der Funktionsschicht 8 abgeschiedenen ersten leitfähigen oxidischen Teilschicht 9.1, aus einer metallischen, elektrisch gut leitfähigen Teilschicht 9.2 und einer zweiten leitfähigen oxidischen Teilschicht 9.3.

Die bevorzugte Licht-Abstrahlrichtung der Funktionsschicht 8 und der Durchtritt der Lichtstrahlen durch die substratferne Flächenelektrode 9 (in der top-Emitter-Anwendung) ist durch eine Schar von Pfeilen gekennzeichnet.

Die Teilschichten des Interferenz-Schichtsystems werden bevorzugt durch Gleichstrom-Kathodenzerstäubung (DC-Zerstäubung) im Vakuum abgeschieden, ggf. mit Magnetfeld-Unterstützung (Magnetron-Sputtern). Dieses Verfahren ist an sich seit langem bekannt und mannigfach beschrieben worden. Hinsichtlich konkreter Zerstäubungsparameter (Arbeitsgas, Sauerstoff-Teildrücke, Schichtdicken, Zerstäubungsraten) kann deshalb auf den einschlägigen Stand der Technik, insbesondere DE 199 48 839 A1 verwiesen werden.

In einer bevorzugten Ausführungsform bestehen die beiden leitfähigen Oxidschichten aus ITO und die metallische Schicht aus Silber, ggf. mit einem geringen Kupferanteil von etwa 10 Gew.-%, um deren Härte und damit mechanische Widerstandsfähigkeit zu erhöhen. Anstelle von ITO kann auch Indium-Cer-Oxid (ICO) als oxidische leitfähige Schicht abgeschieden werden.

Die substratnahe Elektrode 7 kann ebenfalls aus ITO bestehen. Sie muss nicht transparent sein und ist z. B. 150 nm dick; die Funktionsschicht 8 ist 50 bis 500 nm, vorzugsweise 150 nm dick, die Dicke der Teilschicht 9.1 beträgt zwischen 30 und 70 nm, die metallische Teilschicht 9.2 ist 5 bis 20 nm und die oxidische Teilschicht 9.3 ist 30 - 70 nm dick. Diese Dickenverhältnisse sind in Fig. 2 annähernd berücksichtigt, obwohl diese natürlich nicht maßstäblich sein kann.

Die Lichttransmission der Flächenelektrode 9 liegt bei 80 % (gegen Luft) und mehr. Ihr Flächenwiderstand beträgt insgesamt weniger als 4 Ω / Quadrateinheit, ganz bevorzugt bei weniger als 3 Ω / Quadrateinheit, wobei 2,5 Ω / Quadrateinheit ideal wären. Damit wird eine hervorragende Eignung des damit ausgestatteten Flächenelements als top-emitter für großflächige Anwendungen der bereits erwähnten Art erreicht, die auch mit den bevorzugt anzuwendenden geringen Spannungen von weniger als 10 V betrieben werden können.

## Patentansprüche

1. Verfahren zum Herstellen von organischen, Licht emittierenden Flächenelementen (O-LED), wobei auf einem Substrat (1) nacheinander zunächst eine erste Elektrode, eine organische Funktionsschicht und eine zweite Elektrode aufgetragen werden, **dadurch gekennzeichnet, dass** man die zweite Flächenelektrode in Gestalt eines transparenten Interferenz-Schichtsystems mit n metallischen Teilschichten (9.2) und n+1 transparenten leitfähigen oxidischen Teilschichten (9.1, 9.3), die jeweils paarweise eine metallische Teilschicht zwischen sich einschließen, herstellt, mit ganzzahligem n ≥ 1.

2. Verfahren nach Anspruch 1, **dadurch gekennzeichnet, dass** die Teilschichten durch DC-Zerstäubung oder durch gepulste DC-Zerstäubung oder durch AC-überlagerte DC-Zerstäubung (Magnetron-Sputtern) abgeschieden werden.

3. Verfahren nach Anspruch 1 oder 2, **dadurch gekennzeichnet, dass** die oxidischen Teilschichten (9.1, 9.3) in reaktiver Arbeitsatmosphäre aus metallischen oder Legierungskathoden zerstäubt werden.

4. Verfahren nach Anspruch 1 oder 2, **dadurch gekennzeichnet, dass** die oxidischen Teilschichten (9.1, 9.3) in inerter Arbeitsatmosphäre aus oxidischen Kathoden zerstäubt werden.

5. Verfahren nach einem der vorstehenden Ansprüche, **dadurch gekennzeichnet, dass** die oxidischen Teilschichten (9.1, 9.3) als Indium-Zinn-Oxid oder als Indium-Cer-Oxid abgeschieden werden.

6. Verfahren nach einem der vorstehenden Ansprüche, **dadurch gekennzeichnet, dass** die metallische(n) Teilschicht(en) (9.2) in inerter Arbeitsatmosphäre aus Silber oder aus einer Legierung von Silber mit einem anderen Metall, insbesondere mit Kupfer, abgeschieden werden.

7. Verfahren nach einem der vorstehenden Ansprüche, **dadurch gekennzeichnet, dass** die substratferne Flächenelektrode (9) als Schichtsystem mit einem Flächenwiderstand von weniger als 3 Ω/Quadrateinheit, vorzugsweise von weniger als 2,5 Ω/Quadrateinheit abgeschieden wird und dass ihre Lichttransmission für sichtbares Licht höher als 80 % ist.

8. Verfahren nach einem der vorstehenden Ansprüche, **dadurch gekennzeichnet, dass** während des Abscheidens der substratfernen Flächenelektrode (9) eine Substrattemperatur von 80 °C nicht überschritten wird, und ggf, durch Kühlen des Substrats und der bereits darauf abgeschiedenen Schichten begrenzt wird.

9. Verfahren nach einem der vorstehenden Ansprüche, **dadurch gekennzeichnet, dass** bei einer Gesamtdicke der substratfernen Flächenelektrode (9) von vorzugsweise 150 nm die oxidischen Teilschichten mit Dicken zwischen 30 und 70 nm und die metallische(n) Teilschicht(en) mit Dicken zwischen 5 und 20 nm abgeschieden werden.

10. Licht emittierendes Flächenelement mit einem Substrat (1), einer substratnahen Elektrode (7), einer organischen, zum Emittieren von Licht geeigneten und aktivierbaren Funktionsschicht (8) und einer substratfernen transparenten Elektrode (9), insbesondere hergestellt nach einem Verfahren nach einem der vorstehenden Verfahrensansprüche, **dadurch gekennzeichnet, dass** die substratferne transparente Flächenelektrode (9) ein Interferenz-Schichtsystem mit n metallischen Teilschichten (9.2) und n+1 transparenten leitfähigen oxidischen Teilschichten (9.1, 9.3) umfasst, die jeweils paarweise eine metallische Teilschicht zwischen sich einschließen, besteht, wobei n ganzzahlig und ≥ 1 ist.

11. Flächenelement nach Anspruch 10, dessen Substrat (1) aus Glas, einer Kunststofffolie oder einem Wafer besteht.

12. Flächenelement nach Anspruch 10 oder 11, dessen substratferne Flächenelektrode (9) mindestens zwei oxidische Teilschichten (9.1, 9.3) aus Indium-Zinn-Oxid oder Indium-Cer-Oxid und mindestens eine metallische Teilschicht (9.2) aus Silber, oder aus einer Silberlegierung mit einem anderen Metall, vorzugsweise mit Kupfer, umfasst.

13. Flächenelement nach einem der vorstehenden Produktansprüche, dessen Funktionsschicht (8) in Pixel zur Herstellung eines pixelweise aktivierbaren top-Emitter-Displays unterteilt ist, wobei die substratferne Flächenelektrode (9) als gemeinsame Sammelelektrode für sämtliche Pixel dient.

14. Flächenelement nach einem der Ansprüche 10 bis 12, dessen Funktionsschicht (8) und Elektroden (7, 9) nicht unterteilt sind, um ein homogenes top-Emitter-Leuchtfeld (3) zu bilden.

15. Verwendung eines Flächenelements nach einem der vorstehenden Produktansprüche, als top-emitter-OLED insbesondere für großflächige Anwendungen.
